(19) Europäisches Patentamt
European Patent Office
Office européen des brevets

(11) EP 4 585 715 A1

(12) **EUROPEAN PATENT APPLICATION**

(43) Date of publication:
**16.07.2025 Bulletin 2025/29**

(21) Application number: **24216790.6**

(22) Date of filing: **02.12.2024**

(51) International Patent Classification (IPC):
***C23C 16/18*** *(2006.01)* ***C23C 16/455*** *(2006.01)*

(52) Cooperative Patent Classification (CPC):
**C23C 16/45553; C23C 16/18**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **04.12.2023 KR 20230173232**
**25.09.2024 KR 20240129859**

(71) Applicants:
- **Samsung Electronics Co., Ltd.**
  **Suwon-si, Gyeonggi-do 16677 (KR)**
- **Dnf Co., Ltd.**
  **Daejeon 34366 (KR)**

(72) Inventors:
- **KIM, Jaewoon**
  **Suwon-si, Gyeonggi-do 16677 (KR)**
- **CHOI, Geunho**
  **Suwon-si, Gyeonggi-do 16677 (KR)**
- **PARK, Gyu-Hee**
  **Suwon-si, Gyeonggi-do 16677 (KR)**
- **LEE, Sangick**
  **Daejeon 34366 (KR)**
- **JANG, Se Jin**
  **Daejeon 34366 (KR)**
- **JEON, Sangyong**
  **Daejeon 34366 (KR)**
- **JO, Yohan**
  **Daejeon 34366 (KR)**
- **YOUN, JiHyeon**
  **Daejeon 34366 (KR)**
- **CHO, Younjoung**
  **Suwon-si, Gyeonggi-do 16677 (KR)**

(74) Representative: **Kuhnen & Wacker**
**Patent- und Rechtsanwaltsbüro PartG mbB**
**Prinz-Ludwig-Straße 40A**
**85354 Freising (DE)**

(54) **COMPOSITION FOR DEPOSITING A MOLYBDENUM-CONTAINING THIN FILM, METHOD FOR MANUFACTURING A MOLYBDENUM-CONTAINING THIN FILM, AND MOLYBDENUM-CONTAINING THIN FILM MANUFACTURED THEREBY**

(57) Provided are a composition for depositing a molybdenum-containing thin film, a method for manufacturing a molybdenum-containing thin film, and a molybdenum-containing thin film using the same, the composition for depositing a molybdenum-containing thin film comprising a precursor for thin film deposition comprising a monovalent molybdenum-based compound, a divalent molybdenum-based compound, a trivalent molybdenum-based compound, a tetravalent molybdenum-based compound, a pentavalent molybdenum-based compound, a hexavalent molybdenum-based compound, a zero-valent molybdenum-based compound that binds to at least two organic ligands, or any combination thereof, and a reactant comprising a compound represented by Chemical Formula 1, a compound represented by Chemical Formula 2, or a combination thereof, wherein a molar concentration of the reactant may be about 200 times or less than a molar concentration of the precursor for thin film deposition.

FIG. 1

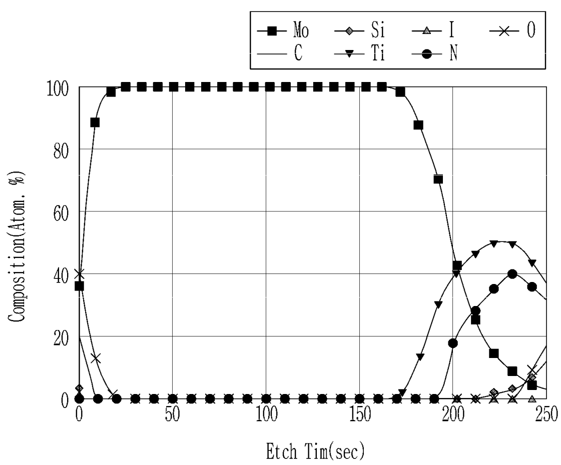


EP 4 585 715 A1

## Description

### FIELD OF THE INVENTION

This disclosure relates to a composition for depositing a molybdenum-containing thin film, a method for manufacturing a molybdenum-containing thin film, and a molybdenum-containing thin film manufactured thereby. More particularly, the present disclosure relates to a method of manufacturing a molybdenum-containing thin film by reacting a molybdenum-based compound with a specific reactant as a precursor for thin film deposition, and to a molybdenum-containing thin film manufactured thereby.

### BACKGROUND OF THE INVENTION

A molybdenum-containing thin film may be used in organic light-emitting diodes, liquid crystal displays, plasma display panels, field emission displays, thin film solar cells, low ohmic resistance, and other electronic devices and semiconductor devices and mainly, as a member of electronic components such as a barrier film and the like.

Molybdenum, molybdenum oxide, and molybdenum nitride are widely used in various fields due to low resistance, a large work function, and thermal·chemical stability. For example, the metal molybdenum has low resistivity of less than or equal to about 15 μΩcm and thus may be applied to wires of display devices, the molybdenum oxide $MoO_2$ exhibits unusual metal-like conductivity and thus may be applied to a hydrocarbon oxidation catalyst, a solid oxide fuel cell (SOFC) anode, and a high-capacity reversable lithium ion battery (LIB) anode, and molybdenum trioxide (MoOs) exhibits electrochromic characteristics and catalyst characteristics and thus may be applied to a gas sensor with a nanostructure and a solid-state lithium ion battery.

On the other hand, for thin film deposition in semiconductor devices, methods such as Molecular Beam Epitaxy (MBE), Chemical Vapor Deposition (CVD), Physical Vapor Deposition (PVD), and the like are being researched. Recently, as the semiconductor devices have been down-sized, an atomic layer deposition (ALD) method according to a self-limiting surface reaction mechanism is being widely studied as a thin film deposition method satisfying a low temperature process, precise thickness control, and uniformity and coating property of a thin film.

Raw materials for the chemical vapor growth method for manufacturing thin films including molybdenum oxide may include organic molybdenum compounds such as molybdenum carbonyl [$Mo(CO)_6$], molybdenum acetylacetonate, molybdenum chloride ($MoCl_3$ or $MoCl_5$), molybdenum fluoride ($MoF_6$), $MoO_2$(2,2,6,6-tetramethylheptane-3,5-dione)$_2$, biscyclopentadienyl molybdenum dihydride, bismethylcyclopentadienyl molybdenum dihydride, bisethylcyclopentadienyl molybdenum dihydride, bisisopropylcyclopentadienyl molybdenum dihydride, biscyclopentadienyl molybdenum imide, and molybdenum oxychloride (MoOzClz or $MoOC_4$). Additionally, molybdenum amide imide compounds have been reported as raw materials for forming thin films including molybdenum by ALD.

However, the conventional molybdenum-containing thin film deposition process uses oxygen as a reaction gas, and thus there is a problem in that a reduction process is necessary.

Therefore, a method for manufacturing a high-purity molybdenum-containing thin film by reducing the content of impurities in the thin film through a simple process is required.

### SUMMARY OF THE INVENTION

One aspect of the present disclosure is to implement a composition for depositing a molybdenum-containing thin film that can form a high-purity molybdenum-containing thin film.

Another aspect of the present disclosure is to implement a method for manufacturing a molybdenum-containing thin film using a precursor for depositing a molybdenum-containing thin film and a specific reactant, and a molybdenum-containing thin film manufactured thereby.

A composition for depositing a molybdenum-containing thin film according to one aspect of the present disclosure comprises:

a precursor for thin film deposition comprising a monovalent molybdenum-based compound, a divalent molybdenum-based compound, a trivalent molybdenum-based compound, a tetravalent molybdenum-based compound, a pentavalent molybdenum-based compound, a hexavalent molybdenum-based compound, a zero-valent molybdenum-based compound that binds to at least two organic ligands, or any combination thereof, and

a reactant comprising a compound represented by Chemical Formula 1, a compound represented by Chemical Formula 2, or a combination thereof,

wherein a molar concentration of the reactant may be about 200 times or less than a molar concentration s of the precursor for thin film deposition.

[Chemical Formula 1]

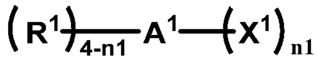

[Chemical Formula 2]

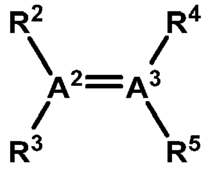

In Chemical Formula 1 and Chemical Formula 2,

A’ to $A^3$ are each independently C, Si, Ge, Sn, or Ti,
$R^1$ is hydrogen or a hydrocarbon group,
$X^1$ is a halogen atom or a hydrocarbon group substituted with at least one halogen atom,
n1 is an integer from 1 to 3, and
$R^2$ to $R^5$ are each independently hydrogen, a halogen atom, a hydrocarbon group, or a hydrocarbon group substituted with at least one halogen atom,
provided that at least one of $R^2$ to $R^5$ is a halogen atom or a hydrocarbon group substituted with at least one halogen atom.

A method for manufacturing a molybdenum-containing thin film according to another aspect of the present disclosure comprises,

a) providing a substrate to the reaction chamber;
b) providing transport gas, and
a precursor for thin film deposition comprising a monovalent molybdenum-based compound, a divalent molybdenum-based compound, a trivalent molybdenum-based compound, a tetravalent molybdenum-based compound, a pentavalent molybdenum-based compound, a hexavalent molybdenum-based compound, a zero-valent molybdenum-based compound that binds to at least two organic ligands, or any combination thereof in a gas phase to the reaction chamber; and
c) providing a reactant comprising a compound represented by Chemical Formula 1, a compound represented by Chemical Formula 2, or a combination thereof in the gas phase to the reaction chamber,
wherein the reactant is supplied at a molar concentration of about 200 times or less, e.g., 1 to 200 times, per second relative to a molar concentration supplied per second of the precursor for thin film deposition.

[Chemical Formula 1]

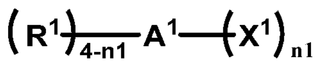

[Chemical Formula 2]

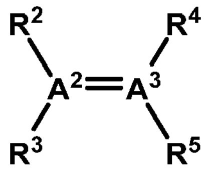

In Chemical Formula 1 and Chemical Formula 2,

A’ to $A^3$ are independently C, Si, Ge, Sn, or Ti,
$R^1$ is hydrogen or a hydrocarbon group,
$X^1$ is a halogen atom or a hydrocarbon group substituted with at least one halogen atom,
n1 is an integer from 1 to 3, and
$R^2$ to $R^5$ are independently hydrogen, a halogen atom, hydrocarbon group or a hydrocarbon group substituted with at least one halogen atom,
provided that at least one of $R^2$ to $R^5$ is a halogen atom or a hydrocarbon group substituted with at least one halogen atom.

According to another aspect, a molybdenum-containing thin film manufactured using the aforementioned manufacturing method is provided.

The method for manufacturing the molybdenum-containing thin film according to one aspect of the present disclosure can provide a high-purity molybdenum-containing thin film by using a composition for depositing a molybdenum-containing thin film.

The method for manufacturing the molybdenum-containing thin film according to another aspect of the present disclosure can use various molybdenum-based compounds as precursors and can minimize the content of impurities such as carbon by using the specific reactant other than oxygen.

## BRIEF DESCRIPTION OF THE DRAWINGS

FIG. 1 shows the results of X-ray photoelectron spectroscopy (XPS) according to etch time for an exemplary molybdenum-containing thin film according to Example 1.
FIG. 2 shows the results of X-ray photoelectron spectroscopy (XPS) according to etch time for an exemplary molybdenum-containing thin film according to Example 2.
FIG. 3 shows the results of X-ray photoelectron spectroscopy (XPS) according to etch time for an exemplary molybdenum-containing thin film according to Comparative Example 1.
FIG. 4 shows resistivity results according to silicon content.
FIG. 5 is a transmission electron microscope photograph of a substrate with a trench structure on which an exemplary molybdenum-containing thin film was deposited according to Example 1.
FIG. 6 shows the results of Energy Dispersive X-Ray Spectrometer (EDS) mapping on a trench structured substrate on which an exemplary molybdenum-containing thin film was deposited according to Example 1.
FIG. 7 shows the results of EDS mapping analysis according to the positions of the top, middle, and bottom parts at high magnification of an exemplary trench structure according to Example 1.
FIG. 8 shows the results of EDS mapping analysis according to the positions of the top, middle, and bottom parts at high magnification of an exemplary trench structure according to Comparative Example 1.
FIG. 9 shows the X-ray diffraction pattern of an exemplary molybdenum-containing thin film according to Example 1.
FIG. 10 is a transmission electron microscope photograph of an exemplary molybdenum-containing thin film according to Example 1.
FIG. 11 is a transmission electron microscope photograph showing the growth rate according to the number of depositions of an exemplary molybdenum-containing thin film according to Example 9.
FIG. 12 shows a correlation between thickness and resistivity according to the number of depositions of an exemplary molybdenum-containing thin film according to Example 9.

## DETAILED DESCRIPTION OF THE EMBODIMENTS

The present disclosure will be described more fully hereinafter with reference to the accompanying drawings, in which example embodiments of the invention are shown. The invention may be implemented in many different forms and is not limited to the embodiments described herein.

In order to clearly describe the present disclosure, parts which are not related to the description are omitted, and the same reference numeral refers to the same or like components, throughout the specification.

The size and thickness of each constituent element as shown in the drawings are randomly indicated for better understanding and ease of description, and this disclosure is not necessarily limited to as shown. In the drawings, the thickness of layers, regions, etc., are enlarged for clarity. In the drawings, for convenience of explanation, the thicknesses of some layers and regions are exaggerated.

In addition, it will be understood that when an element such as a layer, film, region, or substrate is referred to as being "on" another element, it can be directly on the other element or intervening elements may also be present. In contrast, when an element is referred to as being "directly on" another element, there are no intervening elements present. Also, to be disposed "on" or "above" the reference portion is to be disposed above or below the reference portion and does not necessarily mean "on" or "above" toward an opposite direction of gravity.

In addition, unless explicitly described to the contrary, the word "comprise," and variations such as "comprises" or "comprising," will be understood to imply the inclusion of stated elements but not the exclusion of any other elements.

The term "about," as used herein when referring to a measurable value such as time, temperature, molar concentration, atomic percentage, or other measurement and the like, is meant to encompass variations of +/- 10%, +/- 5%, +/- 1%, +/- 0.5%, or even +/- 0.1% of the specified amount.

As used herein, "substituted" refers to replacement of at least one hydrogen by a substituent selected from a halogen atom (F, Cl, Br, or I), a hydroxy group, a C1 to C20 alkoxy group, a nitro group, a cyano group, an amine group, an imino group, an azido group, an amidino group, a hydrazine group, a hydrazone group, a carbonyl group, a carbamyl group, a thiol group, an ester group, an ether group, a carboxyl group or a salt thereof, a sulfonic acid group or a salt thereof, a phosphoric acid group or a salt thereof, a C1 to C20 alkyl group, a C2 to C20 alkenyl group, a C2 to C20 alkynyl group, a C6 to C20 aryl group, a C3 to C20 cycloalkyl group, a C3 to C20 cycloalkenyl group, a C3 to C20 cycloalkynyl group, a C2 to

C20 heterocycloalkyl group, a C2 to C20 heterocycloalkenyl group, a C2 to C20 heterocycloalkynyl group, a C3 to C20 heteroaryl group, or a combination thereof.

Additionally, throughout the specification, unless otherwise defined, "hydrocarbon group" may be a C1 to C10 hydrocarbon group. For example, it may be a C1 to C10 alkyl group, a C2 to C10 alkenyl group, or a C2 to C10 alkynyl group, and more specifically, a C1 to C10 alkyl group or a C2 to C10 alkenyl group. The C1 to C10 alkyl group may be linear or branched, and may be a chain or cyclic. In some embodiments, it may be a methyl group, an ethyl group, a propyl group, a butyl group, a pentyl group, a hexyl group, a heptyl group, an octyl group, a nonyl group, a decyl group, and the like. The C2 to C10 alkenyl group may be linear or branched, and may be a chain or cyclic. In some embodiments, it may be an ethenyl group, a propenyl group, a butenyl group, a pentenyl group, a hexenyl group, a heptenyl group, an octenyl group, a nonenyl group, a decenyl group, and the like. All of the above alkenyl groups may have one or two double bonds.

Additionally, the "hydrocarbon group" of the present disclosure may or may not include a substituent, and when substituted, the substituent may be, for example, a halogen or a C1 to C5 haloalkyl group.

The present disclosure provides a composition for depositing a molybdenum-containing thin film comprising:

a precursor for thin film deposition comprising a monovalent molybdenum-based compound, a divalent molybdenum-based compound, a trivalent molybdenum-based compound, a tetravalent molybdenum-based compound, a pentavalent molybdenum-based compound, a hexavalent molybdenum-based compound, a zero-valent molybdenum-based compound that binds to at least two organic ligands, or any combination thereof, and

a reactant comprising a compound represented by Chemical Formula 1, a compound represented by Chemical Formula 2, or a combination thereof,

wherein a molar concentration supplied per second of the reactant may be about 200 times or less than a molar concentration supplied per second of the precursor for thin film deposition.

[Chemical Formula 1]

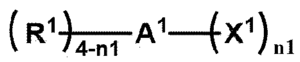

[Chemical Formula 2]

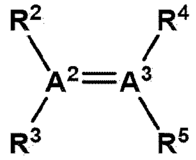

wherein, in Chemical Formula 1 and Chemical Formula 2,

A' to $A^3$ are each independently C, Si, Ge, Sn, or Ti,

$R^1$ is hydrogen or a hydrocarbon group,

$X^1$ is a halogen atom or a hydrocarbon group substituted with at least one halogen atom,

n1 is an integer from 1 to 3, and

$R^2$ to $R^5$ are each independently hydrogen, a halogen atom, a hydrocarbon group, or a hydrocarbon group substituted with at least one halogen atom,

provided that at least one of $R^2$ to $R^5$ is a halogen atom or a hydrocarbon group substituted with at least one halogen atom.

In some embodiments of Chemical Formula 1, when n1 is 2 or more, each $X^1$ may be the same or different from each other.

In some embodiments of Chemical Formula 1, when 4-n1 is 2 or more, each $R^1$ may be the same or different from each other.

Some halogen-containing molybdenum precursors, which are in a solid state when depositing thin films, have limitations in terms of mass productivity, and some molybdenum precursors include organic ligands and are in a liquid state at room temperature. However, when using these to deposit a thin film using ALD and CVD methods, carbon derived from the organic ligand remains in the thin film to form a MoCx type thin film, causing resistance deterioration problems. Because it is thermodynamically much more stable to form a Mo-C bond than the Mo form, it can be very difficult to suppress MoCx formation even when using $H_2$, a reactive gas commonly used when depositing metal thin films, and it can be very difficult to obtain a high-purity Mo thin film even if post-treatment processes are used under oxidation or reduction conditions.

In the present disclosure, a material with a specific structure containing a halogen atom is used as a reactant and at the same time, special process conditions can be applied to develop a composition and thin film manufacturing method which are capable of forming a high-purity, low-resistance Mo thin film with a Mo content (sum amount of Mo and O when molybdenum oxide is included) of 97 atomic percentage (at%) or more, which, in some embodiments, comprises using a halogen-containing molybdenum precursor with a high melting point (over 100°C) that does not contain organic ligands,

which may also comprise using a molybdenum precursor that includes organic ligands and exists as a liquid at room temperature.

For example, a molar concentration supplied per second of the reactant may be about 1 to about 200 times a molar concentration supplied per second of the precursor for thin film deposition, and can be adjusted within the above range according to thin film deposition conditions. As an example, in the case of atomic layer deposition (ALD) or plasma enhanced atomic layer deposition (PEALD), the molar concentration supplied per second of the reactant may be about 1 to about 100 times, specifically about 1 to about 50 times, and more specifically 1 to 25 times the molar concentration supplied per second of the precursor for thin film deposition.

For example, in some embodiments, the monovalent molybdenum-based compound, the divalent molybdenum-based compound, the trivalent molybdenum-based compound, the tetravalent molybdenum-based compound, and/or the pentavalent molybdenum-based compound may combine with at least one organic ligand.

The zero-valent molybdenum-based compound can combine with at least two organic ligands.

The organic ligand may be a substituted or unsubstituted C4 to C10 organic group including carbonyl or a conjugation structure (e.g., a structure comprising alternating single and double bonds).

As an example, in some embodiments, the organic ligand may be carbonyl, substituted or unsubstituted cyclopentadiene, substituted or unsubstituted allyl, or substituted or unsubstituted benzene.

As a specific example, the organic ligand may be carbonyl, a substituted or unsubstituted cyclopentadiene, a substituted or unsubstituted allyl, a substituted or unsubstituted benzene, a substituted or unsubstituted xylene, a substituted or unsubstituted toluene, a substituted or unsubstituted aniline, a substituted or unsubstituted alkoxybenzene, or a substituted or unsubstituted alkylbenzoate.

In an embodiment of the present disclosure, the organic ligand may or may not include a substituent, and when substituted, the substituent may be, for example, a halogen, a C1 to C10 aminoalkyl group, a C1 to C10 alkoxyalkyl group, a C1 to C10 alkylsilyl group, a C1 to C10 alkyl group, a C1 to C10 haloalkyl group, or a C1 to C10 alkoxy group.

In some embodiments, the precursor for thin film deposition may be at least one selected from molybdenum fluoride ($MoF_6$), (2-dimethylaminoethyl)cyclopentadienyl tricarbonyl molybdenum hydride, (2-methoxyethyl)cyclopentadienyl tricarbonyl molybdenum hydride, trimethylsilylcyclopentadienyl dicarbonyl molybdenum 2-methylallyl, isopropylcyclopentadienyl dicarbonyl molybdenum 2-methylallyl, molybdenumchloride ($MoCl_3$ or $MoCl_5$), molybdenum iodide ($MoI_3$), bis(η6-benzene)molybdenum), bis(η6-methylbenzene)molybdenum, bis(η6-ethylbenzene)molybdenum, bis(η6-1,2-ortho-xylene)molybdenum, bis(η6-tertiary-butylbenzene)molybdenum, bis(η6-fluorobenzene)molybdenum, bis(η6-trifluorotoluene)molybdenum, bis(η6-dimethylaniline)molybdenum, bis(η6-methoxybenzene)molybdenum, bis(η6-methylbenzoate)molybdenum, (η6-fluorobenzene)(η6-methylbenzene)molybdenum, (η6-fluorobenzene) (η6-1, 2-ortho-xylene)molybdenum, (η6-fluorobenzene)(η6-tertiary-butylbenzene)molybdenum, (η6-fluorobenzene)(η6-N,N-dimethylaniline)molybdenum, (η6-fluorobenzene)(η6-methoxybenzene)molybdenum, (η6-fluorobenzene)(η6-methylbenzoate)molybdenum, (η6-methylbenzoate)(η6-1,2-ortho-xylene) molybdenum, ((CHs)zN(CHz)zCp)MoH(CO)s, $((CH_3)O(CH_2)_2Cp)MoH(CO)_3$, bis((2-dimethylaminoethyl)cyclopentadienyl)molybdenum dihydride ($C_5H_4(CH_2CH_2N(CH_3)_2))_2MoH_2$), bis((2-methoxyethyl)cyclopentadienyl) molybdenum dihydride ($C_5H_4(CH_2CH_2O(CH_3)))_2MoH_2$), bis(ethylcyclopentadienyl) molybdenum dihydride, and bis(isopropylcyclopentadienyl) molybdenum dihydride, or any combination thereof.

In an embodiment, the precursor for thin film deposition may be at least one selected from (2-dimethylaminoethyl) cyclopentadienyl tricarbonyl molybdenum hydride, (2-methoxyethyl)cyclopentadienyl tricarbonyl molybdenum hydride, trimethylsilylcyclopentadienyl dicarbonyl molybdenum 2-methylallyl, isopropylcyclopentadienyl dicarbonyl molybdenum 2-methylallyl, bis(η6-benzene) molybdenum, bis(η6-methylbenzene) molybdenum, bis(η6-ethylbenzene) molybdenum, bis((2-dimethylaminoethyl)cyclopentadienyl) molybdenum dihydride ($C_5H_4(CH_2CH_2N(CH_3)_2))_2MoH_2$), bis((2-methoxyethyl)cyclopentadienyl) molybdenum dihydride ($C_5H_4(CH_2CH_2O(CH_3)))_2MoH_2$), bis(ethylcyclopentadienyl) molybdenum dihydride, and bis(isopropylcyclopentadienyl) molybdenum dihydride, or any combination thereof.

The reactant may be at least one selected from $CH_3I$, $CH_2I_2$, $CHI_3$, $CH_3CH_2I$, $CH_3CHI_2$, $ICH_2CH_2I$, $CH_3CH_2CH_2I$, $CH_3CHICH_3$, $ICH_2CH_2CH_2I$, $(CH_3)_3CI$, CHBrs, $CH_2Br_2$, $CH_3CHBr_2$, $CHCl_3$, $CH_2Cl_2$, $(CH_3)_2CHCl$, $SiHI_3$, $SiH_2I_2$, $SiH_3I$, $SiHF_3$, $SiH_2F_2$, $SiH_3F$, $SiHCl_3$, $SiH_2Cl_2$, $SiH_3Cl$, $SiHBr_3$, $SiH_3Br$, $SnHI_3$, $SnH_2I_2$, $SnH_3I$, $SnHF_3$, $SnH_2F_2$, $SnH_3F$, $SnHCl_3$, $SnH_2Cl_2$, $SnH_3Cl$, $SnHBr_3$, $SnH_3Br$, $SnH_2Br_2$, $CH_2CHI$, $CH_2C(I)_2$, ICHCHI, $CH_2CHCH_2I$, $CH_2ClCH_3$, and $ICHCHCH_2I$, or any combination thereof.

In an embodiment, the reactant may be at least one selected from $CH_3I$, $CH_2I_2$, $CHI_3$, $CH_3CH_2I$, $CH_3CHI_2$, $ICH_2CH_2I$, $CH_3CH_2CH_2I$, $CH_3CHICH_3$, $ICH_2CH_2CH_2I$, $(CH_3)_3CI$, $SiHI_3$, $SiH_2I_2$, and $SiH_3I$, or any combination thereof.

Hereinafter, methods for manufacturing a molybdenum-containing thin film using the composition for depositing a molybdenum-containing thin film and a molybdenum-containing thin film using the same will be described.

In an embodiment of the present disclosure, a method for manufacturing a molybdenum-containing thin film comprises

a) providing a substrate to the reaction chamber;

b) providing transport gas, and
a precursor for thin film deposition comprising a monovalent molybdenum-based compound, a divalent molybdenum-based compound, a trivalent molybdenum-based compound, a tetravalent molybdenum-based compound, a pentavalent molybdenum-based compound, a hexavalent molybdenum-based compound, a zero-valent molybdenum-based compound that binds to at least two organic ligands, or any combination thereof in a gas phase to the reaction chamber; and
c) providing a reactant comprising a compound represented by Chemical Formula 1, a compound represented by Chemical Formula 2, or a combination thereof in the gas phase to the reaction chamber,

wherein the reactant is supplied at a molar concentration of about 200 times or less per second relative to a molar concentration supplied per second of the precursor for thin film deposition.

[Chemical Formula 1]

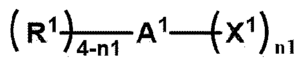

[Chemical Formula 2]

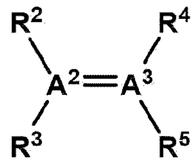

wherein, in Chemical Formula 1 and Chemical Formula 2,
A' to $A^3$ are each independently C, Si, Ge, Sn, or Ti,
$R^1$ is hydrogen or a hydrocarbon group,
$X^1$ is a halogen atom or a hydrocarbon group substituted with at least one halogen atom,
n1 is an integer from 1 to 3, and
$R^2$ to $R^5$ are each independently hydrogen, a halogen atom, a hydrocarbon group, or a hydrocarbon group substituted with at least one halogen atom,
provided that at least one of $R^2$ to $R^5$ is a halogen atom or a hydrocarbon group substituted with at least one halogen atom.

In some embodiments, in Chemical Formula 1, when n1 is 2 or more, each $X^1$ may be the same or different from each other.
In some embodiments, in Chemical Formula 1, when 4-n1 is 2 or more, each $R^1$ may be the same or different from each other.
The method for manufacturing a molybdenum-containing thin film of the present disclosure can provide a high-purity thin film with a controlled carbon content in the thin film by using a combination of a specific molybdenum precursor for thin film deposition and a specific reactant, and due to the high reactivity of the precursor and reactant for thin film deposition, not only carbon but also impurities, for example halogen, silicon, etc. other than carbon can be controlled. In particular, in some embodiments, when the supply molar concentration ratio per second of the reactant is adjusted to be 200 times or less relative to the precursor for thin film deposition, a high-purity Mo thin film with total impurities of less than 3 at% can be manufactured.
In an embodiment,

A' to $A^3$ in Chemical Formula 1 and Chemical Formula 2 may each independently be C, Si, Sn, or Ti, and
in Chemical Formula 1, $R^1$ may each independently be hydrogen or a C1 to C5 alkyl group, and $X^1$ may be a halogen atom or a C1 to C5 haloalkyl group.

In addition, in an embodiment, $R^2$ to $R^5$ in Chemical Formula 2 may each independently be hydrogen, a halogen atom, a C1 to C5 alkyl group, or a C1 to C5 haloalkyl group, and at least one of $R^2$ to $R^5$ may be a halogen atom or a C1 to C5 haloalkyl group.
In a specific embodiment of the present disclosure,

A' to $A^3$ in Chemical Formula 1 and Chemical Formula 2 may each independently be C, Si, or Sn, and
in Chemical Formula 1, $R^1$ may be hydrogen or a C1 to C5 alkyl group, and $X^1$ may be Cl, Br, I or a C1 to C5 alkyl group substituted with one or more of Cl, Br, and I.

In addition, in an embodiment, $R^2$ to $R^5$ in Chemical Formula 2 may each independently be hydrogen; Cl; Br; I; a C1 to C5 alkyl group; or a C1 to C5 alkyl group substituted with one or more of Cl, Br, and I, and at least one of $R^2$ to $R^5$ may

be Cl; Br; I; or a C1 to C5 alkyl group substituted with one or more of Cl, Br, and I.

In the most specific embodiment of the present disclosure, $X^1$ in Chemical Formula 1 may be I or a C1 to C5 alkyl group substituted with one or more I.

Additionally, in an embodiment, at least one of $R^2$ to $R^5$ in Chemical Formula 2 may be I; or a C1 to C5 alkyl group substituted with one or more I.

In an embodiment, a usable substrate may include a substrate including one or more semiconductor materials selected from Si, Ge, SiGe, GaP, GaAs, SiC, SiGeC, InAs, and InP; SOI (Silicon On Insulator) substrate; quartz substrate; or a glass substrate for display; a flexible plastic substrate such as polyimide, polyethylene terephthalate (PET), polyethylene naphthalate (PEN), polymethylmethacrylate (PMMA), polycarbonate (PC), polyethersulfone (PES), and polyester; a tungsten substrate, but is not limited thereto.

Any substrate according to an embodiment can be used as long as it is within the range recognized by a person skilled in the art, and the temperature of the substrate is also not limited, but may be desirably about 80 to about 600 °C, specifically about 100 to about 600 °C, or about 200 to about 600 °C. The temperature range may be due to the decomposition characteristics of the molybdenum-based precursor itself used as a precursor and the reaction characteristics with other substances, such as the reactant represented by Chemical Formula 1 or Chemical Formula 2.

In the method for manufacturing a molybdenum-containing thin film according to an embodiment, a molybdenum-based compound as a precursor for thin film deposition and a reactant represented by Chemical Formula 1 or Chemical Formula 2 may be supplied to the reaction chamber together or independently of each other. Additionally, the molybdenum-based compound and the reactant may each be supplied to the reaction chamber continuously or discontinuously, and the discontinuous supply may include a pulse form.

For example, the step of providing a precursor for thin film deposition in b) and the step of providing a reactant in c) may be supplied to the reaction chamber continuously or discontinuously, in which step c) may be performed after step b), or step b) may be performed after step c).

In a method for manufacturing a molybdenum-containing thin film according to an embodiment, in the case of liquid compounds at room temperature and pressure among the molybdenum-based compounds used as precursors for thin film deposition, they can be changed to a gaseous state by heating or other methods and then introduced into the reaction chamber for thin film deposition.

In a method for manufacturing a molybdenum-containing thin film according to an embodiment, the reactant represented by Chemical Formula 1 or Chemical Formula 2 is changed to a gaseous state by a method such as heating, and may be introduced into a reaction chamber where a substrate to which the molybdenum-based compound as a precursor for thin film deposition is adsorbed exists.

A method for manufacturing a molybdenum-containing thin film according to an embodiment may include atomic layer deposition (ALD), chemical vapor deposition (CVD), metal organic chemical vapor deposition (MOCVD), low pressure chemical vapor deposition (LPCVD), plasma enhanced chemical vapor deposition, (PECVD), or plasma enhanced atomic layer deposition (PEALD), and in terms of having high purity and excellent physical properties, it can be performed by atomic layer deposition (ALD) or chemical vapor deposition (CVD).

In a method for manufacturing a molybdenum-containing thin film according to an embodiment, the molybdenum-based compound may be supplied to the reaction chamber along with the transport gas. Specifically, the transport gas may be any one or two or more selected from nitrogen ($N_2$), hydrogen, argon, and helium, and in a desirable combination with the specific reactant of the present disclosure may be any one or two or more inert gases selected from nitrogen ($N_2$), argon, and helium.

In a method for manufacturing a molybdenum-containing thin film according to an embodiment, post-treatment may be performed after step b) and/or c).

In an embodiment, post-treatment is performed so that unreacted molybdenum compound gas, by-product gas, or unreacted reaction gas can be exhausted.

In another embodiment, a post-treatment may be performed to produce a molybdenum-containing thin film that additionally includes molybdenum oxide.

The post-treatment may include hydrogen treatment, heat treatment, ammonia treatment, oxygen treatment, ozone treatment, treatment with a reactant containing oxygen atoms, or a combination thereof.

Specifically, the heat treatment may be performed at about 200 to about 700 °C, desirably at about 300 to about 600 °C.

In addition, heat treatment may be performed for about 1 minute to about 4 hours, for example, about 5 minutes to about 1 hour.

In addition, heat treatment may be performed under a hydrogen atmosphere.

For example, the reactant containing the oxygen atoms may be at least one of $O_2$, $O_3$, $O_2$ plasma, $H_2O$, $NO_2$, NO, $N_2O$ (nitrous oxide), CO, $CO_2$, $H_2O_2$, HCOOH, $CH_3COOH$, $(CH_3CO)_2O$, alcohol, peroxide, sulfur oxide, or any combination thereof.

In addition, after steps b) and/or c), a purging step may be further performed by supplying an inert gas in the

reaction chamber to exhaust unreacted molybdenum-based compound gas, by-produced gas, or unreacted reaction gas. The inert gas may be any one or two or more selected from nitrogen ($N_2$), argon, and helium.

A method for manufacturing a molybdenum-containing thin film according to an embodiment of the present disclosure comprises

a) maintaining the temperature of a substrate mounted in a reaction chamber at about 80 to about 600 °C;
b) injecting transport gas and molybdenum-based compound; and
c) injecting a reactant that is a compound represented by Chemical Formula 1, a compound represented by Chemical Formula 2, or a combination thereof to manufacture a molybdenum-containing thin film on the substrate.

In a method for manufacturing a molybdenum-containing thin film according to an embodiment, using a molybdenum-based compound as a precursor for thin film deposition and a hydrocarbon compound containing at least one halogen atom as a reactant, and supplying the reactant at a molar concentration of about 200 times or less per second relative to the molar concentration supplied per second of the thin film deposition precursor, corresponding thin film deposition conditions can be adjusted according to the structure or thermal characteristics of the desired thin film.

Deposition conditions according to an embodiment may include an input flow rate of the molybdenum-based compound, which is a precursor for thin film deposition, an input flow rate of the transport gas, pressure, Radio Frequency (RF) power, substrate temperature, and the like and non-limiting examples of these deposition conditions may include input flow rate of about 1 to about 1000 cc/min, or any range therein, pressure of about 0.1 to about 100 torr, or any range therein, RF power of about 200 to about 1000 W, or any range therein, and a substrate temperature of about 80 to about 600 °C, or any range therein, desirably about 100 to about 400 °C, but are not limited thereto.

The reactant according to an embodiment may be supplied at a molar concentration of about 1 to about 200 times per second relative to the molar concentration supplied per second of the molybdenum-containing precursor, and can be adjusted within the above range according to thin film deposition conditions. For example, in the case of atomic layer deposition (ALD) or plasma enhanced atomic layer deposition (PEALD), the reactant may be supplied at a molar concentration per second of about 10 to about 100 times, more desirably about 1 to about 50 times, or most desirably about 1 to about 25 times the molar concentration per second supplied of the molybdenum-containing precursor.

A method for manufacturing a molybdenum-containing thin film according to an embodiment may include a process comprising step a); step b); and step c) which are considered as 1 cycle, and the cycle can be repeated 20 or more cycles, 30 or more cycles, 40 or more cycles, 50 or more cycles, or 60 or more cycles, or specifically 100 or more cycles.

In some embodiments, the cycle may be repeated 50 to 800 times, more specifically 60 to 300 times.

For example, if a process comprising step a); step b); and step c) is repeated in two or more cycles, the post-treatment may be performed for each process cycle, or may be performed after some cycles of the entire process cycle are repeated, or the post-treatment may be performed after some cycles of the entire process cycle are repeated, and then additional post-treatment may be performed after the remaining cycles are completed.

For example, in a case where a process comprising steps a); b); and c) is repeated 800 times, post-treatment may be performed after 400 cycles, which are some of the total 800 cycles, are repeated, and additional post-treatment may be performed after the remaining 400 cycles are completed.

The molybdenum-containing thin film may be any thin film that can be manufactured within the range recognized by a person skilled in the art in the field of manufacturing molybdenum-containing thin films by supplying a molybdenum precursor in the vapor phase. As a specific and practical example, the molybdenum-containing thin film may be a generally conductive molybdenum single film, a molybdenum oxide film, a molybdenum nitride film, or a hybrid film thereof. In addition, various high-quality thin films containing molybdenum can be manufactured within the range recognized by those skilled in the art.

In some embodiments, a molybdenum-containing thin film manufactured by the aforementioned method for manufacturing a molybdenum-containing thin film is provided, and the prepared molybdenum-containing thin film may have a resistivity of less than or equal to about 200 $\mu\Omega\cdot$cm.

The molybdenum-containing thin film according to an embodiment may have a molybdenum content of greater than or equal to about 97 at%, and specifically greater than or equal to about 99 at%.

The molybdenum-containing thin film according to an embodiment may have a carbon content of less than about 1 at%.

In an embodiment of the present invention, the molybdenum-containing thin film may include molybdenum oxide, and the molybdenum oxide may be $MoO_2$, MoOs, or a combination thereof.

When the molybdenum-containing thin film includes molybdenum oxide, the molybdenum-containing thin film may have a total content of molybdenum (Mo) and oxygen (0) of greater than or equal to about 97 at%.

The molybdenum-containing thin film according to an embodiment may have a silicon content of less than or equal to about 3 at%.

The molybdenum-containing thin film according to an embodiment may have a content of other impurities, such

as halogen, of less than about 1 at%.

The molybdenum-containing thin film can be manufactured with high purity, high density, and high durability by reacting a molybdenum-based compound with a halogen-containing hydrocarbon compound, which is a specific reactant. In addition, in some embodiments, the content of impurities can be minimized by using the aforementioned specific reactant rather than hydrogen when manufacturing the molybdenum-containing thin film, thereby preventing an increase of the contact resistance between the molybdenum-containing thin film and the lower film due to the oxide formed at the interface with the lower film.

In addition, when manufacturing molybdenum-containing thin films, in some embodiments, the crystal quality is improved by using molybdenum-based compounds and specific reactants, so that the resistivity of the thin film may be lowered to about 200 $\mu\Omega\cdot cm$ or less, in some embodiments, desirably about 100 $\mu\Omega\cdot cm$ or less, and in some embodiments, more desirably about 45 $\mu\Omega\cdot cm$ or less, and the carbon content in the thin film may be reduced to less than about 1 at%.

Although example embodiments have been described above, the present disclosure is not limited to the aforementioned example embodiments, and various additions, omissions, substitutions, and changes may be made. Additionally, it is possible to provide other embodiments by combining elements from different embodiments.

Hereinafter, the present disclosure will be explained in more detail by the following examples. The terms or words used in this specification and claims should not be construed as limited to their usual or dictionary meanings, and based on the principle that the inventor can appropriately define the concept of the term in order to explain his or her invention in the best way, it should be interpreted as meaning and concept consistent with the technical idea of the present disclosure.

Therefore, the configuration shown in the embodiments described in this specification is only one of the most desirable embodiments of the present disclosure and does not represent the entire technical idea of the present disclosure, so that it should be understood that at the time of filing this application, there are various equivalents and modifications that can replace them.

In addition, all of the following examples were performed using a known atomic layer deposition (ALD) method using a 200 mm Showerhead Type ALD equipment (CN1, Atomic Premium) in the form of a single wafer type, which is a commercially proven equipment concept.

The resistivity of the deposited molybdenum-containing thin film was measured using a sheet resistance meter (4point probe, DASOLENG, ARMS-200C), thickness was measured using a scanning electron microscope (Hitachi, S-4800) and a transmission electron microscope (FEI (Netherlands) Tecnai $G^2$F30S-Twin), and the properties of the formed thin film were analyzed by analyzing the components within the thin film using X-ray photoelectron spectroscopy (XPS) (ThermoFisher Scientific, K-Alpha).

**Manufacture of Molybdenum-containing Thin Film**

<u>Example 1, Example 2, and Comparative Example 1</u>

A molybdenum-containing thin film was formed by using bis(η6-ethylbenzene)molybdenum ($Mo(EtBz)_2$) as a molybdenum-containing precursor and diiodosilane ($SiH_2I_2$) as a reactant in an atomic layer deposition method.

After placing a substrate deposited with titanium nitride on a silicon oxide layer in a vacuum-maintained chamber and then, maintaining it at 375 °C, the bis(η6-ethylbenzene)molybdenum ($Mo(EtBz)_2$) as a molybdenum-containing precursor was filled in a stainless steel bubbler container and maintained at 98 °C. The bis(η6-ethylbenzene)molybdenum ($Mo(EtBz)_2$) vaporized in the stainless steel bubbler container was transferred at a supply molar concentration of 0.718 μmol/sec for 5 seconds onto silicon oxide layer substrate to be absorbed therein by using argon gas (50 sccm) as a transport gas. Subsequently, the unreacted (non-adsorbed) bis(η6-ethylbenzene)molybdenum ($Mo(EtBz)_2$) was removed for 3 seconds by using argon gas (3000 sccm). Then, the reactant of $SiH_2I_2$ filled in the stainless steel bubbler container and vaporized at 13 °C to 80 °C was supplied for 0.1 second to form a molybdenum-containing thin film. Lastly, a reaction by-product and residual reaction gas were removed therefrom by using argon gas (3000 sccm). The diiodosilane ($SiH_2I_2$) as the reactant was supplied respectively at 25 times (18.0 μmol/sec, Example 1), 100 times (71.8 μmol/sec, Example 2), and 300 times (215 μmol/sec, Comparative Example 1) molar concentrations based on the molar concentration per second (0.718 μmol/sec) of the molybdenum-containing precursor (bis(η6-ethylbenzene)molybdenum ($Mo(EtBz)_2$)). The above process as one cycle was repeated for 800 cycles to form the molybdenum-containing thin film. The detailed reaction conditions are shown in Table 1.

Table 1

| | Example 1 | Example 2 | Comparative Example 1 |
|---|---|---|---|
| Substrate temperature (°C) | 375 °C | 375 °C | 375 °C |

(continued)

| | | Example 1 | Example 2 | Comparative Example 1 |
|---|---|---|---|---|
| Mo precursor | Heating temperature (°C) | 98 °C | 98 °C | 98 °C |
| | Transport gas flow rate (sccm) | 50 | 50 | 50 |
| | Injection time (sec) | 5 s | 5 s | 5 s |
| Purge (argon) | Flow rate (sccm) | 3000 sccm | 3000 sccm | 3000 sccm |
| | Time (sec) | 3 s | 3 s | 3 s |
| Reactant: $SiH_2I_2$ | Heating temperature (°C) | 13 °C | 46 °C | 80 °C |
| | Injection time (sec) | 0.1 s | 0.1 s | 0.1 s |
| | Supply molar concentration per second (ratio to Mo precursor supply molar concentration per second) | 18.0 μmol/sec (25 times) | 71.8 μmol/sec (100 times) | 215 μmol/sec (300 times) |
| Purge | Flow rate (sccm) | 3000 sccm | 3000 sccm | 3000 sccm |
| | Time (sec) | 3 s | 3 s | 3 s |
| Number of depositions | Cycles | 800 | 800 | 800 |

Each of the formed thin films was measured with respect to sheet resistance in a four-point Probe method and a thickness with a scanning electron microscope (SEM), and a composition of each thin film was checked through X-ray photoelectron spectroscopy (XPS), wherein the sheet resistance and thickness measurements were inserted into Equation 1 to calculate resistivity of each thin film.

[Equation 1]

$$\text{Resistivity, } \rho\ [\mu\Omega cm] = \text{thin film thickness x sheet resistance}$$

Each of the molybdenum-containing thin films according to the number of moles per second of the reactant to the number of moles per second of the molybdenum-containing precursor for depositing a thin film was analyzed through X-ray photoelectron spectroscopy (XPS) according to etch time, and the results are shown in FIGS. 1 to 3.

FIG. 1 shows the results of X-ray photoelectron spectroscopy (XPS) according to etch time for the molybdenum-containing thin film according to Example 1.

FIG. 2 shows the results of X-ray photoelectron spectroscopy (XPS) according to etch time for the molybdenum-containing thin film according to Example 2.

FIG. 3 shows the results of X-ray photoelectron spectroscopy (XPS) according to etch time for the molybdenum-containing thin film according to Comparative Example 1.

Referring to FIGS. 1 to 3, Example 1 using the reactant at 25 times molar concentration per second exhibited 99 at% or more of Mo, which confirmed that a high-purity molybdenum-containing thin film was obtained, compared with Comparative Example 1 using the reactant at 300 times molar concentration per second exhibited less than 40 at% of Mo.

In particular, Example 1 exhibited almost 0 at% of an Si content and Example 2 exhibited about 3 at% of an Si content, but Comparative Example 1 exhibited 66 at% of an Si content, in which disadvantageous resistivity results were expected.

In this regard, FIG. 4 shows resistivity results according to silicon content.

Referring to FIG. 4, as expected in FIGS. 1 to 3, as the silicon content was increased, the resistivity was increased.

In other words, the number of moles of the reactant was adjusted to lower the silicon content, forming a high-purity molybdenum-containing thin film having low resistivity.

Meanwhile, FIG. 5 is a transmission electron microscope photograph of a substrate with a trench structure on which a molybdenum-containing thin film was deposited according to Example 1, and FIG. 6 shows the results of EDS (Energy Dispersive X-Ray Spectrometer) mapping on a trench structured substrate on which a molybdenum-containing thin film was deposited according to Example 1.

Referring to FIGS. 5 and 6, Mo was evenly deposited inside the trench structure.

FIG. 7 shows the results of EDS mapping analysis according to the positions of the top, middle, and bottom parts

at high magnification of the trench structure according to Example 1.

FIG. 8 shows the results of EDS mapping analysis according to the positions of the top, middle, and bottom parts at high magnification of the trench structure according to Comparative Example 1.

Referring to FIG. 7, almost no silicon was deposited, but referring to FIG. 8, silicon along with molybdenum was also evenly deposited, in which side effects (high resistivity) according to the silicon content were expected.

FIG. 9 shows the X-ray diffraction pattern of the molybdenum-containing thin film according to Example 1.

Referring to FIG. 9, a peak corresponding to Mo was found with high intensity.

FIG. 10 is a transmission electron microscope photograph of a molybdenum-containing thin film according to Example 1.

Referring to FIG. 10, a crystalline structure of the molybdenum-containing thin film was checked.

Comparative Example 2

Compound 1 ( 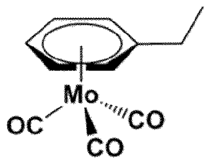 )

as the molybdenum-containing precursor and diiodinemethane ($CH_2I_2$) as the reactant were used in the atomic layer deposition method to form a molybdenum-containing thin film.

First, a silicon oxide layer substrate was maintained at 250 °C, and Compound 1 was filled in a stainless steel bubbler container and maintained at 70 °C. Compound 1 vaporized in the stainless steel bubbler container was transferred to the silicon oxide layer substrate for 1 second (0.0003 g) to be absorbed in the silicon oxide layer substrate by using argon gas (50 sccm) as a transport gas. Subsequently, unreacted Compound 1 was removed for 10 seconds by using argon gas (4000 sccm). Then, diiodinemethane ($CH_2I_2$) heated to 90 °C was supplied thereto for 0.5 seconds (0.00625 g) to form a molybdenum-containing thin film. Lastly, a reaction by-product and residual reaction gas were removed therefrom by using argon gas (4000 sccm) for 30 seconds. The reactant (diiodinemethane) was supplied at 22.2 times molar concentrations per second based on the molar concentration per second of the molybdenum-containing precursor (Compound 1). This process as one cycle was repeated for 800 cycles to form the molybdenum-containing thin film. Detailed reaction conditions are shown in Table 2.

The formed molybdenum-containing thin film was heat-treated under a hydrogen atmosphere at 500 °C for 2 hours.

Table 2

| Comparative Example 2 | | |
|---|---|---|
| Substrate temperature (°C) | | 250 °C |
| Mo precursor | Heating temperature (°C) | 70 °C |
| | Injection time (sec) | 1 s |
| Purge (argon) | Flow rate (sccm) | 4000 |
| | Time (sec) | 10 s |
| Reaction gas: $CH_2I_2$ | Heating temperature (°C) | 90 |
| | Injection time (sec) | 0.5 s |
| Purge (argon) | Flow rate (sccm) | 4000 sccm |
| | Time (sec) | 30 s |
| Number of depositions | cycle | 800 |

Table 3 shows resistivity calculated by using a thickness and sheet resistance of the molybdenum-containing thin film of Comparative Example 2 and its composition obtained through X-ray photoelectron spectroscopy.

Table 3

| Resistivity | Composition (atomic%) | | |
|---|---|---|---|
| μΩ·cm | Mo | O | C |
| 108 | 69.3 | 5.0 | 25.7 |

Referring to Table 3, Comparative Example 2 was different from the present invention in that a zero-valent molybdenum-based compound binding one organic ligand as a precursor for depositing a thin film was used, wherein Example 1 using a zero-valent molybdenum-based compound binding at least two organic ligands as a precursor for depositing a thin film had a higher Mo content but lower O and C contents than Comparative Example 2 and thus turned out to form a high-purity molybdenum-containing thin film.

Example 3

A molybdenum-containing thin film was formed in the same manner as in Example 2 except that the injection order of the bis(η6-ethylbenzene)molybdenum ($Mo(EtBz)_2$) and the diiodosilane ($SiH_2I_2$) in Example 2 was switched.

A composition of the film was analyzed through X-ray photoelectron spectroscopy (XPS), and the result is shown in Table 4.

Table 4

| Resistivity | Composition (atomic%) | | | | |
|---|---|---|---|---|---|
| μΩ·cm | Mo | Si | I | O | C |
| 20.1 | 97.3 | 2.7 | 0.0 | 0.0 | 0.0 |

Referring to Table 4, even though the injection order was changed, the thin film with the same composition was obtained.

Example 4

After forming the molybdenum-containing thin film of Example 2, a heat treatment was performed under a hydrogen atmosphere. A composition of the thin film was analyzed through X-ray photoelectron spectroscopy (XPS), and the result is shown in Table 5.

Table 5

| | Resistivity | Composition (atomic%) | | | | |
|---|---|---|---|---|---|---|
| | μΩ·cm | Mo | Si | I | O | C |
| Before heat treatment | 20 | 97.2 | 2.8 | 0.0 | 0.0 | 0.0 |
| After heat treatment | 15 | 97.3 | 2.7 | 0.0 | 0.0 | 0.0 |

Referring to Table 5, as a result of lowering the Si content by performing the heat treatment as a post treatment, resistivity was lowered.

Example 5

The molybdenum-containing thin film of Example 2 was formed, and after injecting a predetermined amount of ammonia gas thereinto reaction by-products and residual reaction gas were removed therefrom by using argon gas. The above series of processes were repeated for predetermined cycles to form a molybdenum-containing thin film. Detailed conditions for manufacturing the thin film are shown in Table 6.

Table 6

| | Example 5 |
|---|---|
| Substrate temperature (°C) | 375 °C |

(continued)

| | | Example 5 | |
|---|---|---|---|
| Mo precursor | Heating temperature (°C) | 98 °C | 20 cycles |
| | Injection time (sec) | 5 s | |
| Purge (argon) | Flow rate (sccm) | 3000 sccm | |
| | Time (sec) | 3 s | |
| Reactant: $SiH_2I_2$ | Heating temperature (°C) | 46°C | |
| | Injection time (sec) | 0.1 s | |
| | Supply molar concentration per second (ratio to Mo precursor supply molar concentration per second) | 71.8 μmol/sec (100 times) | |
| Purge (argon) | Flow rate (sccm) | 3000 sccm | |
| | Time (sec) | 3 s | |
| Ammonia gas | Flow rate (sccm) | 500 sccm | 1 cycle |
| | Time (sec) | 3 s | |
| Purge (argon) | Flow rate (sccm) | 3000 sccm | |
| | Time (sec) | 3 s | |

The result of analyzing a composition of the thin film through X-ray photoelectron spectroscopy (XPS) is shown in Table 7.

Table 7

| Resistivity | Composition (atomic%) | | | | |
|---|---|---|---|---|---|
| μΩ·cm | Mo | Si | I | O | C |
| 19.9 | 97.2 | 2.8 | 0.0 | 0.0 | 0.0 |

Example 6

A molybdenum-containing thin film was formed in the same manner as in Example 2 except that monoiodosilane ($SiH_3I$) as the reactant was used in Example 2.

The result of analyzing a composition of the thin film through X-ray photoelectron spectroscopy (XPS) is shown in Table 8.

Table 8

| Resistivity | Composition (atomic%) | | | | |
|---|---|---|---|---|---|
| μΩ·cm | Mo | Si | I | O | C |
| 19.8 | 97.4 | 2.6 | 0.0 | 0.0 | 0.0 |

Example 7

A molybdenum-containing thin film was formed in the same manner as in Example 2 except that monoiodosilane ($SiH_3I$) as the reactant was used in Example 2.

The result of analyzing a composition of the thin film through X-ray photoelectron spectroscopy (XPS) is shown in Table 9.

Table 9

| Resistivity | Composition (atomic%) | | | | |
|---|---|---|---|---|---|
| μΩ·cm | Mo | Si | I | O | C |

(continued)

| Resistivity | Composition (atomic%) | | | | |
|---|---|---|---|---|---|
| 20.0 | 97.3 | 2.7 | 0.0 | 0.0 | 0.0 |

Example 8

A molybdenum-containing thin film was formed in the same manner as in Example 2 except that molybdenum pentachloride as the molybdenum-containing precursor was used in Example 2.

The result of analyzing a composition of the thin film through X-ray photoelectron spectroscopy (XPS) is shown in Table 10.

Table 10

| Resistivity | Composition (atomic%) | | | | |
|---|---|---|---|---|---|
| μΩ·cm | Mo | Si | I | O | C |
| 20.0 | 97.3 | 2.7 | 0.0 | 0.0 | 0.0 |

Example 9

After forming a molybdenum-containing metal layer by using bis(η6-ethylbenzene)molybdenum ($Mo(EtBz)_2$) as a composition for depositing a molybdenum-containing thin film in a conventional atomic layer deposition (thermal ALD) device using a known atomic layer deposition (ALD) method, the thin film was evaluated according to process cycles (60 to 300 cycles). Herein, diiodinemethane ($CH_2I_2$) as the reactant and nitrogen ($N_2$) as purge gas were used.

In the evaluation according to process cycles, a silicon oxide layer substrate was set at temperature of 400 °C. The molybdenum precursor and the diiodinemethane were charged in a stainless steel bubbler container and respectively maintained at 93 °C and 75 °C.

First, the molybdenum precursor vaporized in the stainless steel bubbler container was transferred to the silicon oxide layer substrate for 5 seconds (0.001 g) to be absorbed in the silicon oxide layer substrate by using 50 sccm of nitrogen gas as a transport gas. Secondly, unabsorbed molybdenum precursor was removed for about 10 seconds by using 1,800 sccm of nitrogen gas. Thirdly, the diiodinemethane vaporized in the stainless steel bubbler container was formed into a molybdenum-containing metal layer by inflowing 25 sccm of nitrogen gas as a transport gas for 0.5 seconds (0.009 g), and lastly, reaction by-products and residual reaction gas were removed therefrom by using 1,800 sccm of nitrogen gas for about 5 seconds. The reactant (diiodinemethane) was supplied at 10.3 times (7.40 μmol/sec) molar concentration per second based on molar concentration (0.718 μmol/sec) per second of the molybdenum precursor. This process as one cycle was repeated for predetermined cycles to form a molybdenum-containing metal film. Detailed conditions for forming the thin film are shown in Table 11.

Table 11

| Example 9 | | |
|---|---|---|
| Substrate temperature (°C) | | 400 °C |
| Mo precursor | Heating temperature (°C) | 93 °C |
| | Transport gas flow rate (sccm) | 50 |
| | Injection time (sec) | 5 s |
| Purge (argon) | Flow rate (sccm) | 1800 |
| | Time (sec) | 10 s |
| reactant: $CH_2I_2$ | Heating temperature (°C) | 75 °C |
| | Transport gas flow rate (sccm) | 25 |
| | Injection time (sec) | 0.5 s |
| | Supply molar concentration per second (ratio to Mo precursor supply molar concentration per second) | 7.40 μmol/sec (10.3 times) |

(continued)

| Example 9 | | |
|---|---|---|
| Substrate temperature (°C) | | 400 °C |
| Purge (argon) | Flow rate (sccm) | 1800 sccm |
| | Time (sec) | 5 s |
| Number of depositions | cycles | 60 to 300 |

FIGS. 11 and 12 show a growth rate of the molybdenum-containing metal layers according to the number of depositions. In addition, a thickness, a growth rate, and resistivity according to the number of depositions are shown in Table 12.

Table 12

| | Number of depositions (cycle) | Film thickness (Å) | Growth rate (Å/cycle) | Resistivity (μΩ·cm) |
|---|---|---|---|---|
| Example 9 | 60 | 39 | 0.65 | 150 |
| | 90 | 59 | 0.66 | 103 |
| | 149 | 102 | 0.68 | 65 |
| | 300 | 200 | 0.67 | 41 |

FIG. 11 is a transmission electron microscope photograph showing the growth rate according to the number of depositions of the molybdenum-containing thin film according to Example 9. FIG. 12 shows a correlation between thickness and resistivity according to the number of depositions of the molybdenum-containing thin film according to Example 9.

Referring to Table 12 and FIGS. 11 and 12, the thickness of the film according to the number of depositions turned out to grow with a predetermined slope. In other words, the number of depositions may be adjusted to control a thickness and resistivity of a thin film, which is expected to contribute to realizing molybdenum-containing thin film with low resistance by easily adjusting its thickness, if necessary.

Accordingly, a substrate temperature of 400 °C, at which a thickness of a thin film is easy to control, may be industrially very useful

Comparative Example 3

After forming a molybdenum-containing metal thin film by using bis(η6-ethylbenzene)molybdenum ($Mo(EtBz)_2$) as a composition for depositing a molybdenum-containing metal thin film but hydrogen gas ($H_2$) instead of the diiodinemethane ($CH_2I_2$) as the reactant in a conventional atomic layer deposition (PEALD) device using a known atomic layer deposition (ALD) method, a thin film evaluation was conducted.

Nitrogen ($N_2$) was used as purge gas.

A silicon substrate was set at a temperature of 400 °C in the evaluation according to a temperature. The molybdenum precursor was filled in a stainless steel bubbler container and maintained at 93 °C. First, the molybdenum precursor vaporized in the stainless steel bubbler container was transferred to the silicon oxide layer substrate for 2 seconds (0.0004 g) to be adsorbed in the silicon oxide layer substrate by using 50 sccm of nitrogen gas as a transport gas. Secondly, the unabsorbed molybdenum precursor was removed for about 10 seconds by using 1,800 sccm of nitrogen gas. Thirdly, 4,000 sccm of hydrogen gas for 10 seconds as a reaction gas were flowed thereinto to form a molybdenum-containing metal film, and lastly, reaction by-products and residual reaction gas were removed therefrom by using 1,800 sccm of nitrogen gas for about 5 seconds. This process as one cycle was repeated for 300 cycles to form the molybdenum-containing metal layer. Detailed conditions for forming the thin film are shown in Table 13.

Table 13

| Comparative Example 3 | | |
|---|---|---|
| Substrate temperature (°C) | | 400 °C |
| Mo precursor | Heating temperature (°C) | 93 °C |
| | Transport gas flow rate (sccm) | 50 |
| | Injection time (sec) | 2 s |
| Purge (argon) | Flow rate (sccm) | 1800 |
| | Time (sec) | 10 s |
| reactant: $H_2$ | Hydrogen flow rate (sccm) | 4000 |
| | Injection time (sec) | 10 s |
| Purge (argon) | Flow rate (sccm) | 1800 sccm |
| | Time (sec) | 5 s |
| number of depositions | cycle | 300 |

A growth rate of the molybdenum-containing metal layer according to the number of depositions of Example 9 is shown in FIGS. 11 and 12. For comparison, a thickness, the growth rate, and resistivity according to the number of depositions of Comparative Example 3 are shown in Table 14.

Table 14

| | Number of depositions (cycle) | Film thickness (Å) | growth rate (Å/cycle) | resistivity (μΩ·cm) |
|---|---|---|---|---|
| Comparative Example 3 | 300 | 80 | 0.27 | $1.6\times 10^8$ |

Referring to Tables 12 and 14, and FIGS. 11 and 12, the molybdenum-containing metal films deposited in Example 9 and Comparative Example 3 using diiodinemethane and hydrogen gas as reactants exhibited about 2.5 times difference in the growth rate and about $25\times 10^8$ times difference in the resistivity. Referring to these results, the molybdenum precursor had very low reactivity with the hydrogen gas but high reactivity with the diiodinemethane, forming a very advantageous thin film in terms of resistivity.

Examples 10 and 11

After forming a molybdenum-containing thin film according to Examples 1 and 2, post-treatment with ozone was performed (process temperature: 300 °C or 350 °C; injection time: 600 sec; flow rate: 1000 sccm). The results of composition analysis using X-ray photoelectron spectroscopy (XPS) are shown in Table 15.

Table 15

| | Post-treatment Temperature (°C) | Composition (atomic%) | | | | |
|---|---|---|---|---|---|---|
| | | Mo | Si | I | O | C |
| Example 10 | 300 | 41.2 | 0.0 | 0.0 | 58.8 | 0.0 |
| | 350 | 41.0 | 0.0 | 0.0 | 59.0 | 0.0 |
| Example 11 | 300 | 38.0 | 2.8 | 0.0 | 59.2 | 0.0 |
| | 350 | 38.1 | 2.7 | 0.0 | 59.2 | 0.0 |

Referring to Table 15, a molybdenum oxide-containing thin film was formed as a result of performing post-treatment with ozone, and the content of Mo included in the molybdenum oxide was high and the contents of I and C were low, forming a high-purity molybdenum oxide-containing thin film.

Examples 12 and 13

In forming a molybdenum-containing thin film according to Examples 1 and 2, after performing half (400 cycles) of the total process cycle (800 cycles), post-treatment with ozone was performed (process temperature: 375 °C; injection time: 300 sec; flow rate: 1000 sccm). After the remaining half of the process cycle (400 cycles) was performed, post-treatment with ozone (process temperature: 375 °C; injection time: 300 sec; flow rate: 1000 sccm) was performed to form a molybdenum-containing thin film. The results of composition analysis using X-ray photoelectron spectroscopy (XPS) are shown in Table 16.

Table 16

| | Composition (atomic%) | | | | |
|---|---|---|---|---|---|
| | Mo | Si | I | O | C |
| Example 12 | 41.0 | 0.0 | 0.0 | 59.0 | 0.0 |
| Example 13 | 38.0 | 2.6 | 0.0 | 59.4 | 0.0 |

Referring to Table 16, molybdenum oxide-containing thin films were formed as a result of performing post-treatment with ozone, and the content of Mo included in the molybdenum oxide were high and the contents of I and C were low, forming high-purity molybdenum oxide-containing thin films.

While the present disclosure has been particularly shown and described with reference to exemplary embodiments thereof, it is to be understood that the invention is not limited to the disclosed exemplary embodiments, but, on the contrary, is intended to cover various modifications and equivalent arrangements included within the scope of the appended claims.

## Claims

**1.** A composition for depositing a molybdenum-containing thin film, comprising

a precursor for thin film deposition comprising a monovalent molybdenum-based compound, a divalent molybdenum-based compound, a trivalent molybdenum-based compound, a tetravalent molybdenum-based compound, a pentavalent molybdenum-based compound, a hexavalent molybdenum-based compound, a zero-valent molybdenum-based compound that binds to at least two organic ligands, or any combination thereof, and

a reactant comprising a compound represented by Chemical Formula 1, a compound represented by Chemical Formula 2, or a combination thereof,

wherein a molar concentration of the reactant is about 1 to 200 times or less than a molar concentration of the precursor for thin film deposition,

[Chemical Formula 1]

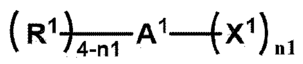

[Chemical Formula 2]

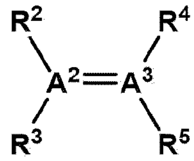

wherein, in Chemical Formula 1 and Chemical Formula 2,

A’ to $A^3$ are each independently C, Si, Ge, Sn, or Ti,

$R^1$ is hydrogen or a hydrocarbon group,

$X^1$ is a halogen atom or a hydrocarbon group substituted with at least one halogen atom,

n1 is an integer from 1 to 3, and

$R^2$ to $R^5$ are each independently hydrogen, a halogen atom, a hydrocarbon group, or a hydrocarbon group substituted with at least one halogen atom,

provided that at least one of $R^2$ to $R^5$ is a halogen atom or a hydrocarbon group substituted with at least one halogen atom.

**2.** The composition for depositing a molybdenum-containing thin film of claim 1, wherein the molar concentration of the reactant is about 1 to about 50 times the molar concentration of the precursor for thin film deposition, or
wherein the molar concentration of the reactant is about 1 to about 25 times the molar concentration of the precursor for thin film deposition.

**3.** The composition for depositing a molybdenum-containing thin film of claim 1 or 2, wherein the organic ligand is a substituted or unsubstituted C4 to C10 organic group including carbonyl or a conjugation structure.

**4.** The composition for depositing a molybdenum-containing thin film of any one of claims 1 to 3, wherein the precursor for thin film deposition is at least one selected from molybdenumfluoride ($MoF_6$), (2-dimethylaminoethyl)cyclopentadienyl tricarbonyl molybdenum hydride, (2-methoxyethyl)cyclopentadienyl tricarbonyl molybdenum hydride, trimethylsilylcyclopentadienyl dicarbonyl molybdenum 2-methylallyl, isopropylcyclopentadienyl dicarbonyl molybdenum 2-methylallyl, molybdenum chloride ($MoCl_3$ or $MoCl_5$), molybdenum iodide ($MoI_3$), bis(η6-benzene)molybdenum, bis(η6-methylbenzene)molybdenum, bis(η6-ethylbenzene)molybdenum, bis(η6-1,2-ortho-xylene)molybdenum, bis(η6-tertiary-butylbenzene)molybdenum, bis(η6-fluorobenzene)molybdenum, bis(η6-trifluorotoluene)molybdenum, bis(η6-dimethylaniline)molybdenum, bis(η6-methoxybenzene)molybdenum, bis(η6-methylbenzoate) molybdenum, (η6-fluorobenzene)(η6-methylbenzene)molybdenum, (η6-fluorobenzene)(η6-1, 2-ortho-xylene)molybdenum, (η6-fluorobenzene)(6-tertiary-butylbenzene)molybdenum, (η6-fluorobenzene)(η6-N,N-dimethylaniline) molybdenum, (η6-fluorobenzene)(η6-methoxybenzene)molybdenum, (η6-fluorobenzene)(η6-methylbenzoate)molybdenum, (η6-methylbenzoate)(η6-1,2-ortho-xylene) molybdenum, $((CH_3)_2N(CH_2)_2Cp)MoH(CO)_3$, $((CH_3)O(CH_2)_2Cp)MoH(CO)_3$, bis((2-dimethylaminoethyl)cyclopentadienyl) molybdenum dihydride $(C_5H_4(CH_2CH_2N(CH_3)_2))_2MoH_2)$, bis((2-methoxyethyl)cyclopentadienyl) molybdenum dihydride $(C_5H_4(CH_2CH_2O(CH_3)))_2MoH_2)$, bis(ethylcyclopentadienyl) molybdenum dihydride, and bis(isopropylcyclopentadienyl) molybdenum dihydride.

**5.** The composition for depositing a molybdenum-containing thin film of any one of claims 1 to 4, wherein the reactant is at least one selected from $CH_3I$, $CH_2I_2$, $CHI_3$, $CH_3CH_2I$, $CH_3CHI_2$, $ICH_2CH_2I$, $CH_3CH_2CH_2I$, $CH_3CHICH_3$, $ICH_2CH_2CH_2I$, $(CH_3)_3CI$, CHBrs, $CH_2Br_2$, $CH_3CHBr_2$, $CHCl_3$, $CH_2Cl_2$, $(CH_3)\ _2CHCl$, $SiHI_3$, $SiH_2I_2$, SiHsI, $SiHF_3$, $SiH_2F_2$, $SiH_3F$, $SiHCl_3$, $SiH_2Cl_2$, $SiH_3Cl$, $SiHBr_3$, $SiH_3Br$, $SnHI_3$, $SnH_2I_2$, $SnH_3I$, $SnHF_3$, $SnH_2F_2$, SnHsF, $SnHCl_3$, $SnH_2Cl_2$, $SnH_3Cl$, $SnHBr_3$, $SnH_3Br$, $SnH_2Br_2$, $CH_2CHI$, $CH_2C(I)_2$, ICHCHI, $CH_2CHCH_2I$, $CH_2ClCH_3$, and $ICHCHCH_2I$.

**6.** A method for manufacturing a molybdenum-containing thin film, comprising:

a) providing a substrate to the reaction chamber;
b) providing transport gas, and
a precursor for thin film deposition comprising a monovalent molybdenum-based compound, a divalent molybdenum-based compound, a trivalent molybdenum-based compound, a tetravalent molybdenum-based compound, a pentavalent molybdenum-based compound, a hexavalent molybdenum-based compound, a zero-valent molybdenum-based compound that binds to at least two organic ligands, or any combination thereof in a gas phase to the reaction chamber; and
c) providing a reactant comprising a compound represented by Chemical Formula 1, a compound represented by Chemical Formula 2, or a combination thereof in the gas phase to the reaction chamber,

wherein the reactant is supplied at a molar concentration of about 1 to 200 times per second relative to a molar concentration supplied per second of the precursor for thin film deposition,

[Chemical Formula 1]

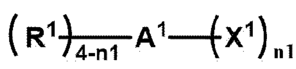

[Chemical Formula 2]

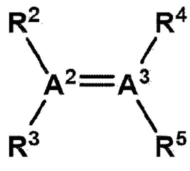

wherein, in Chemical Formula 1 and Chemical Formula 2,
A’ to $A^3$ are each independently C, Si, Ge, Sn, or Ti,
$R^1$ is hydrogen or a hydrocarbon group,

$X^1$ is a halogen atom or a hydrocarbon group substituted with at least one halogen atom,
n1 is an integer from 1 to 3, and
$R^2$ to $R^5$ are each independently hydrogen, a halogen atom, a hydrocarbon group, or a hydrocarbon group substituted with at least one halogen atom,
provided that at least one of $R^2$ to $R^5$ is a halogen atom or a hydrocarbon group substituted with at least one halogen atom.

**7.** The method for manufacturing a molybdenum-containing thin film of claim 6, wherein a temperature of the substrate is maintained at about 80 °C to about 600 °C in a).

**8.** The method for manufacturing a molybdenum-containing thin film of claim 6 or 7, wherein c) is performed after b).

**9.** The method for manufacturing a molybdenum-containing thin film of claim 6 or 7, wherein b) is performed after c).

**10.** The method for manufacturing a molybdenum-containing thin film of any one of claims 7 to 9, wherein a post-treatment is performed after b) and/or c).

**11.** The method for manufacturing a molybdenum-containing thin film of claim 10, wherein the post-treatment comprises hydrogen treatment, heat treatment which is exemplarily performed at about 200 to about 700 °C, ammonia treatment, oxygen treatment, ozone treatment, treatment with a reactant containing oxygen atoms, or a combination thereof.

**12.** The method for manufacturing a molybdenum-containing thin film of claim 11, wherein
the reactant containing the oxygen atoms is at least one of $O_2$, $O_3$, $O_2$ plasma, $H_2O$, $NO_2$, NO, $N_2O$ (nitrous oxide), CO, $CO_2$, $H_2O_2$, HCOOH, $CH_3COOH$, $(CH_3CO)_2O$, alcohol, peroxide, sulfur oxide, and a combination thereof.

**13.** A molybdenum-containing thin film manufactured according to the method of any one of claims 6 to 12.

**14.** The molybdenum-containing thin film of claim 13, wherein

the molybdenum-containing thin film has
a molybdenum content of greater than or equal to about 97 atomic percentage (at%), and/or
a carbon content of less than about 1 at%, and/or
a halogen content of less than about 1 at%.

**15.** The molybdenum-containing thin film of claim 13 or 14, wherein

the molybdenum-containing thin film comprises molybdenum oxide which is $MoO_2$, MoOs, or a combination thereof, and
wherein the molybdenum-containing thin film may have a total content of molybdenum, Mo, and oxygen, 0, of greater than or equal to about 97 at%.

# FIG. 1

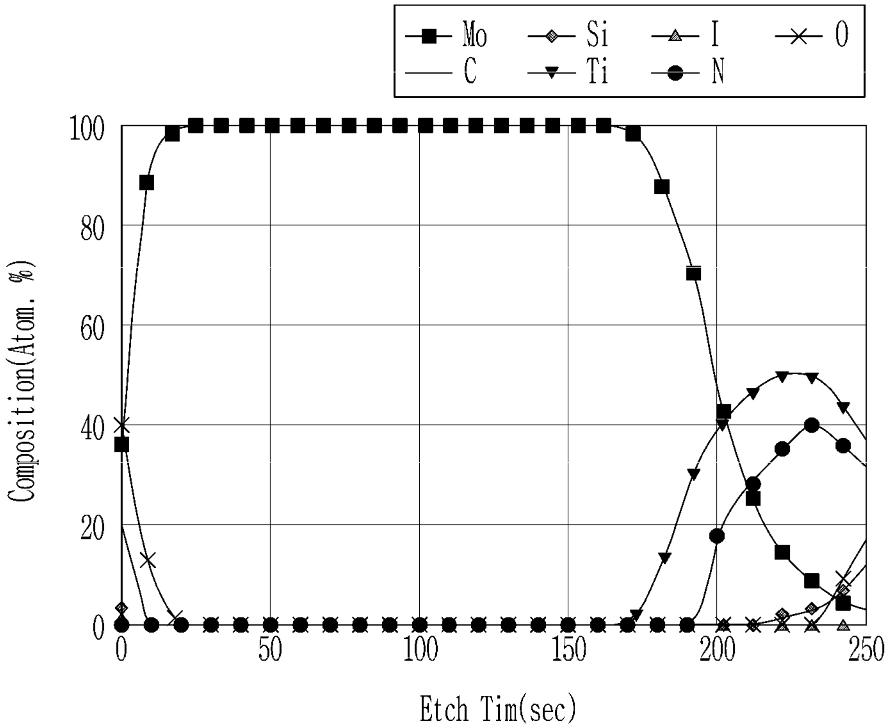
Mo
Si
I
O
C
Ti
N
Composition(Atom. %)
100
80
60
40
20
0
0
50
100
150
200
250
Etch Tim(sec)

# FIG. 2

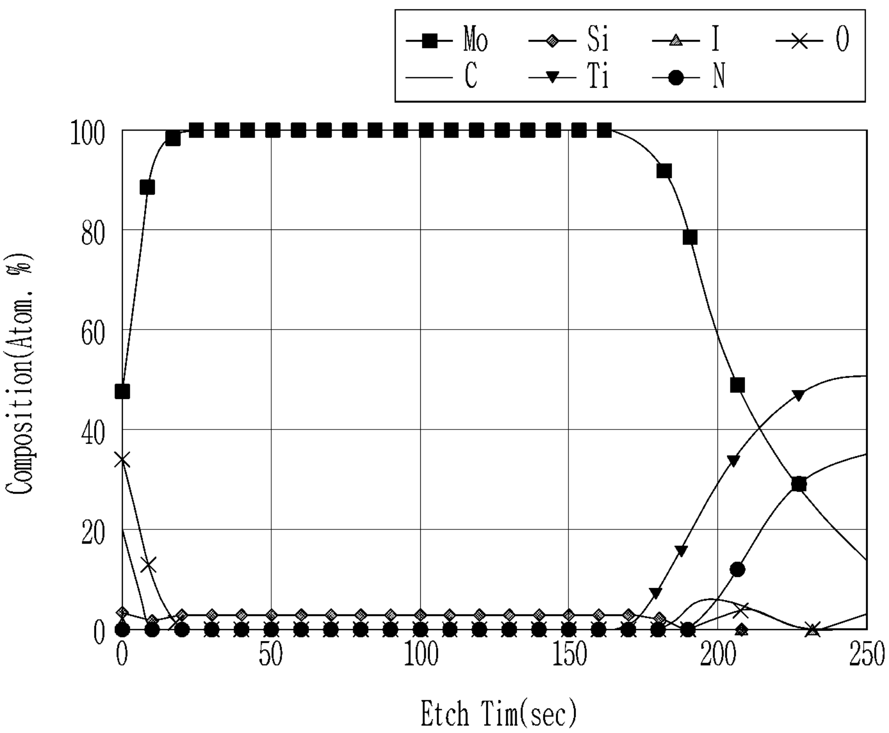
Mo
Si
I
O
C
Ti
N
Composition(Atom. %)
100
80
60
40
20
0
0
50
100
150
200
250
Etch Tim(sec)

FIG. 3

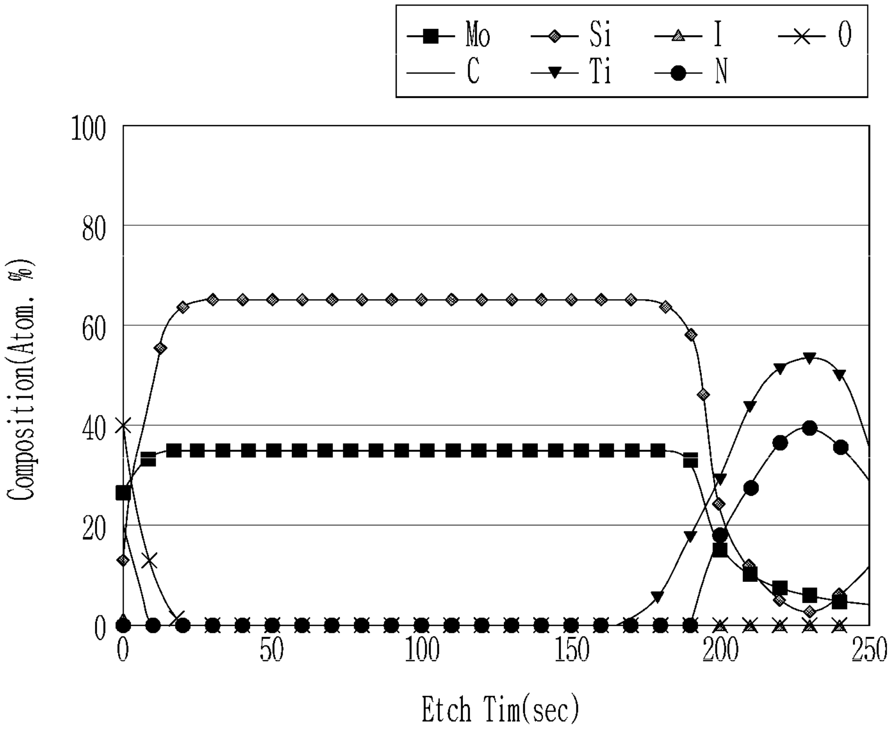
Mo
Si
I
O
C
Ti
N
100
80
60
40
20
0
Composition(Atom. %)
0
50
100
150
200
250
Etch Tim(sec)

FIG. 4

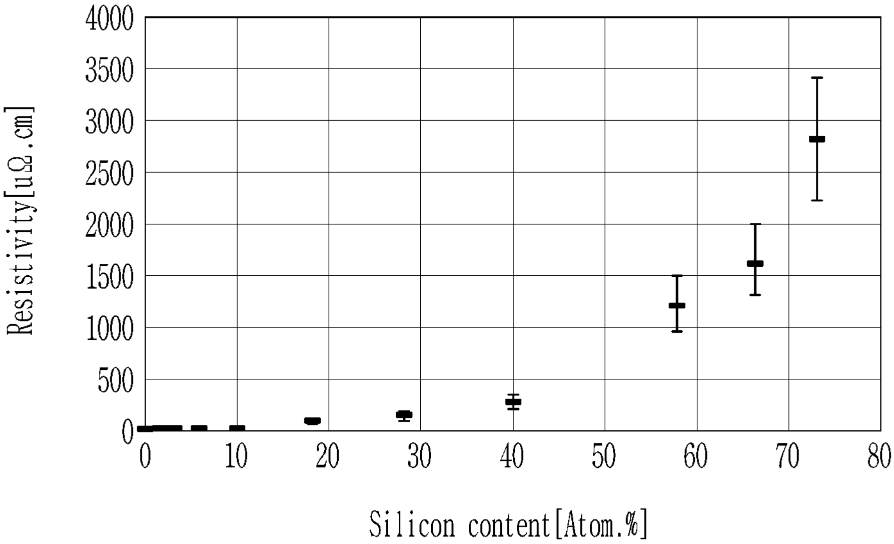
4000
3500
3000
2500
2000
1500
1000
500
0
Resistivity[uΩ.cm]
0
10
20
30
40
50
60
70
80
Silicon content[Atom.%]

FIG. 5

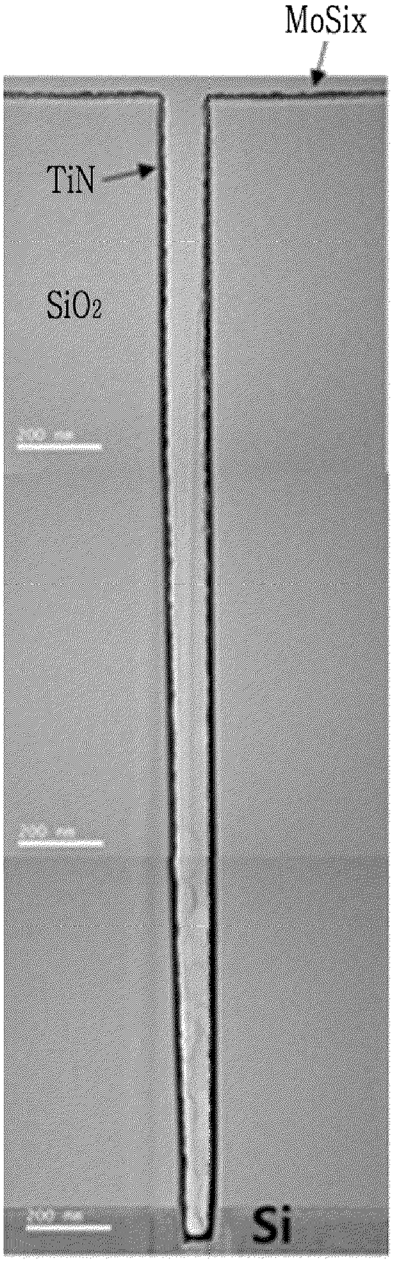


FIG. 6

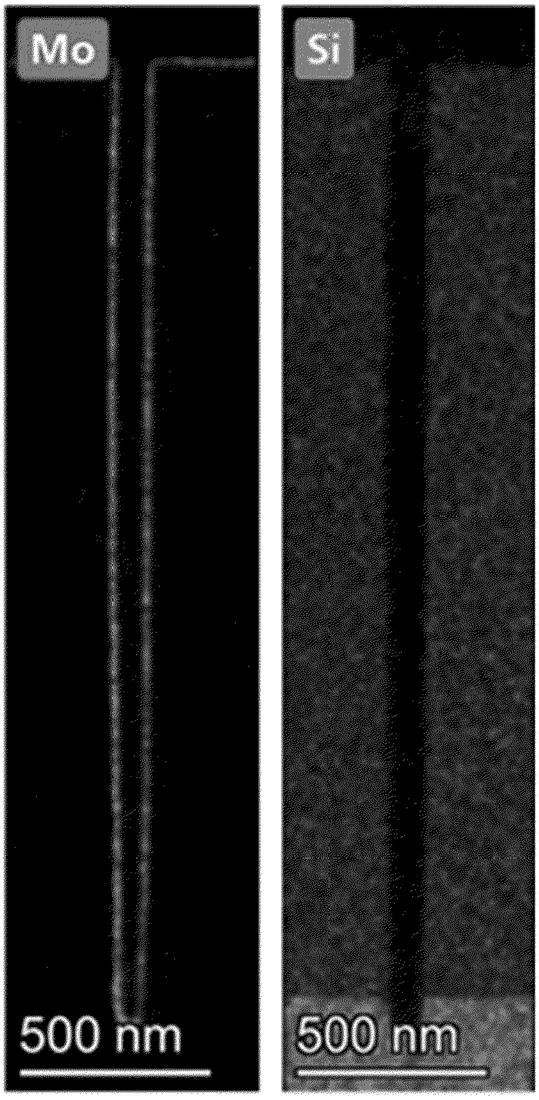

FIG. 7

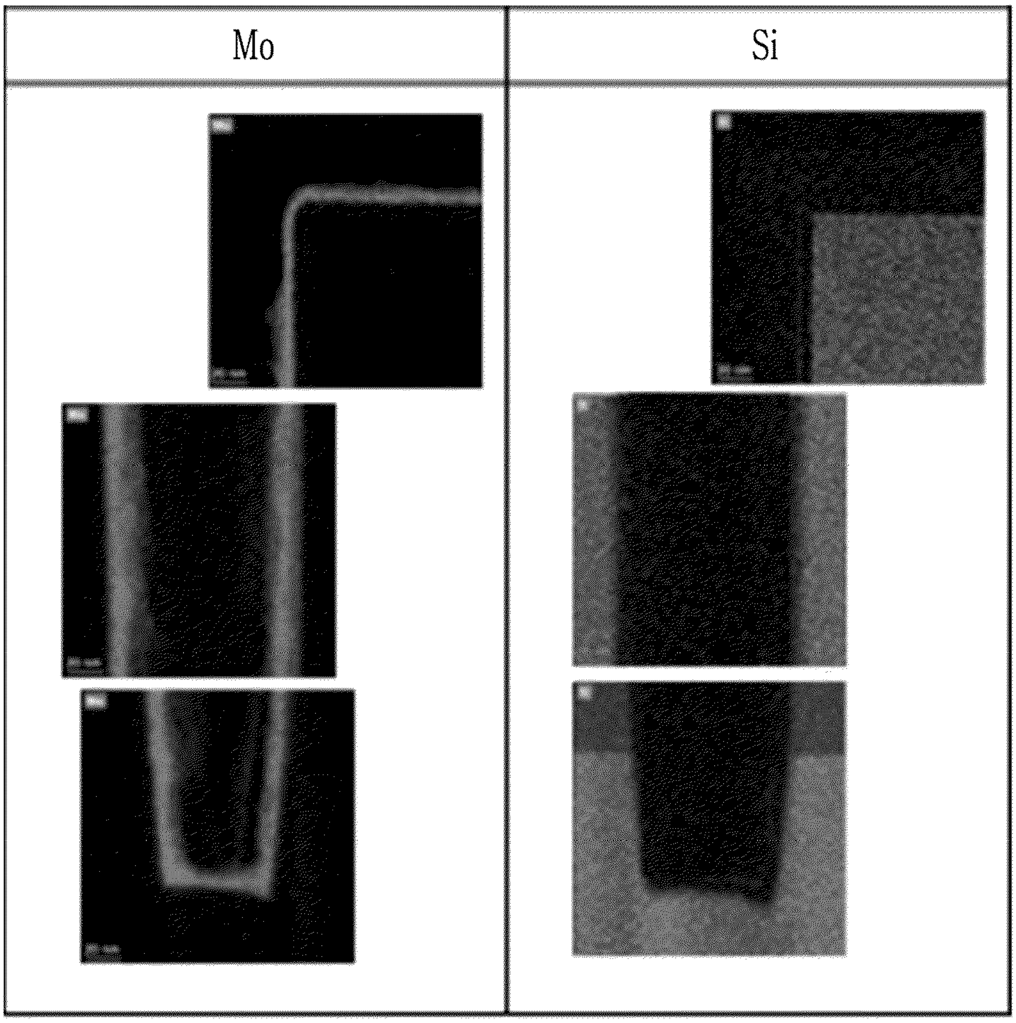

FIG. 8

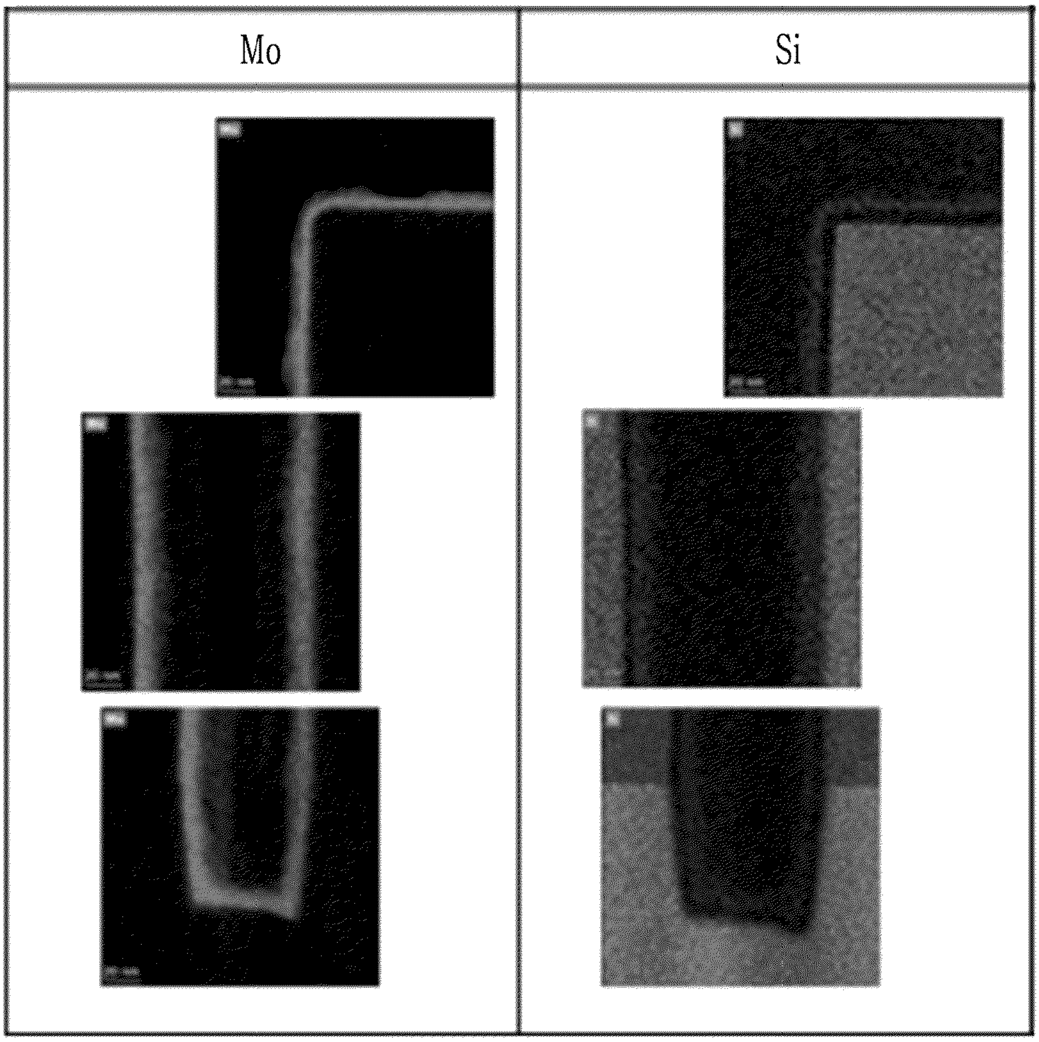

FIG. 9

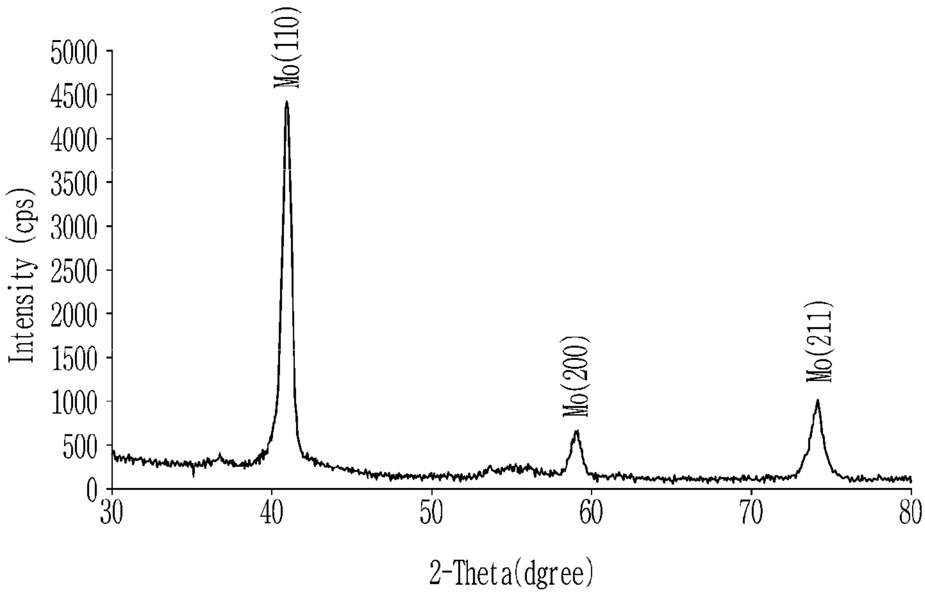
Mo(110)
Mo(200)
Mo(211)
Intensity (cps)
5000
4500
4000
3500
3000
2500
2000
1500
1000
500
0
30
40
50
60
70
80
2-Theta(dgree)

FIG. 10

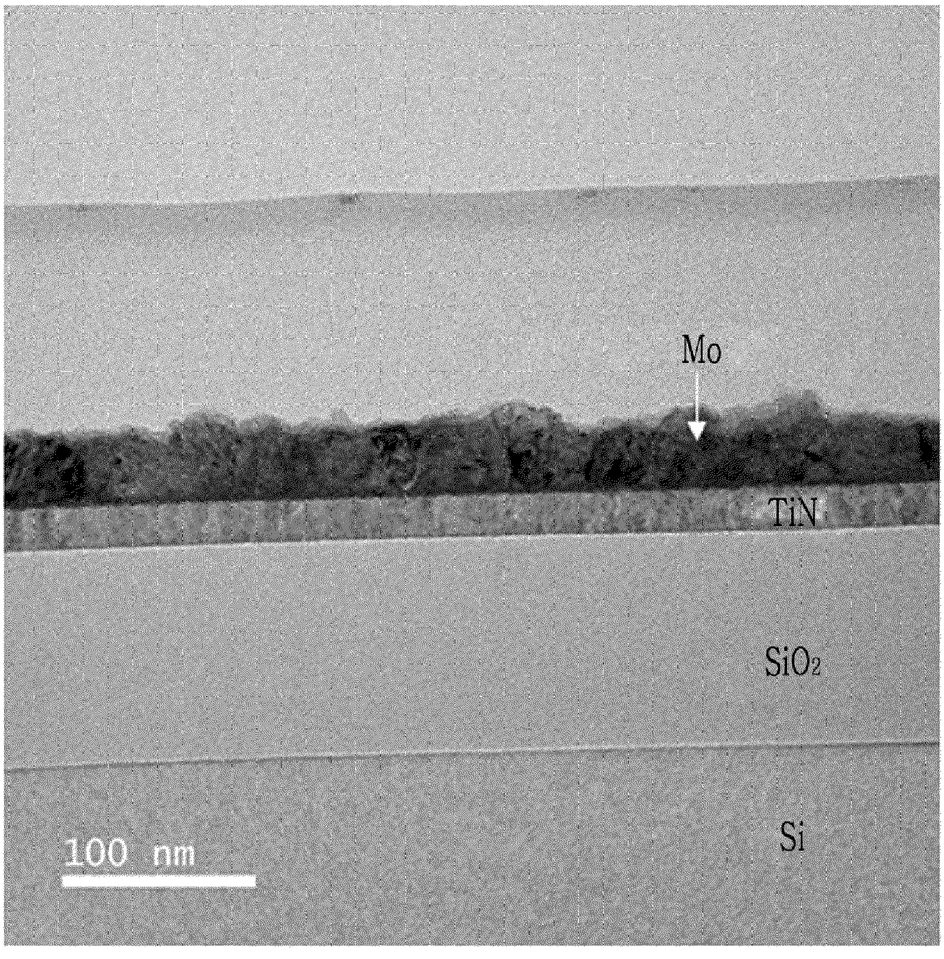
Mo
TiN
SiO2
Si
100 nm

FIG. 11

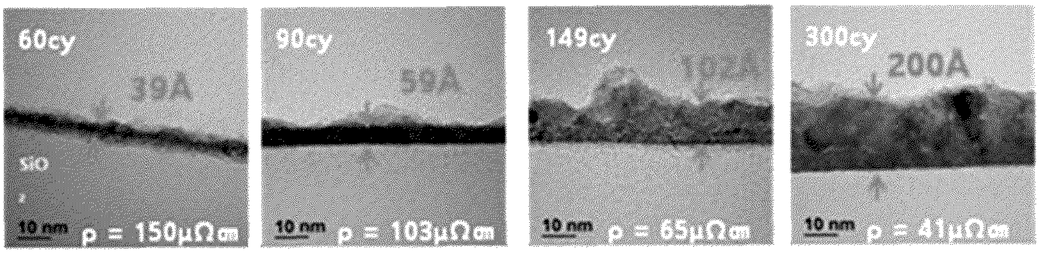
60cy
39A
SiO
2
10 nm
ρ = 150μΩcm
90cy
59A
10 nm
ρ = 103μΩcm
149cy
102A
10 nm
ρ = 65μΩcm
300cy
200A
10 nm
ρ = 41μΩcm

FIG. 12

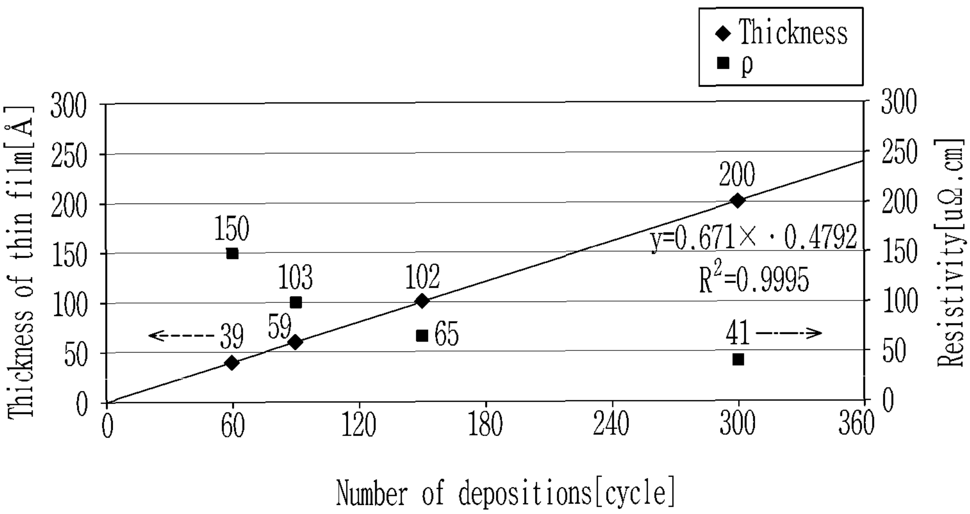
Thickness
ρ
Thickness of thin film[Å]
Resistivity[uΩ.cm]
300
250
200
150
100
50
0
0
60
120
180
240
300
360
150
103
102
200
39
59
65
41
y=0.671× · 0.4792
R2=0.9995
Number of depositions[cycle]

Europäisches Patentamt
European Patent Office
Office européen des brevets

# EUROPEAN SEARCH REPORT

Application Number
EP 24 21 6790

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br><br>Y | US 2022/372053 A1 (ARTEAGA MULLER ROCIO ALEJANDRA [JP] ET AL) 24 November 2022 (2022-11-24)<br>* paragraphs [0044], [0052], [0053], [0131], [0155]; claims 1,13,15 * | 1-5<br><br><br>6-12 | INV.<br>C23C16/18<br>C23C16/455 |
| Y | US 2022/018017 A1 (KIM MYONG WOON [KR] ET AL) 20 January 2022 (2022-01-20)<br>* paragraphs [0072], [0082], [0083] * | 6-12 | |
| X | US 2022/220139 A1 (LEONCINI ANDREA [SG] ET AL) 14 July 2022 (2022-07-14)<br>* paragraphs [0024], [0051] * | 13-15 | |

TECHNICAL FIELDS SEARCHED (IPC)

C23C

The present search report has been drawn up for all claims

1

| Place of search | Date of completion of the search | Examiner |
|---|---|---|
| The Hague | 20 May 2025 | Schuhmacher, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO. EP 24 21 6790

This annex lists the patent family members relating to the patent documents cited in the above-mentioned European search report. The members are as contained in the European Patent Office EDP file on
The European Patent Office is in no way liable for these particulars which are merely given for the purpose of information.

20-05-2025

| Patent document cited in search report | Publication date | Patent family member(s) | Publication date |
|---|---|---|---|
| US 2022372053 A1 | 24-11-2022 | CN 117642523 A | 01-03-2024 |
| | | EP 4341459 A1 | 27-03-2024 |
| | | JP 2024520373 A | 24-05-2024 |
| | | KR 20240008929 A | 19-01-2024 |
| | | TW 202300500 A | 01-01-2023 |
| | | US 2022372053 A1 | 24-11-2022 |
| | | WO 2022246140 A1 | 24-11-2022 |
| US 2022018017 A1 | 20-01-2022 | CN 112969814 A | 15-06-2021 |
| | | JP 7171916 B2 | 15-11-2022 |
| | | JP 2022510566 A | 27-01-2022 |
| | | KR 20200056543 A | 25-05-2020 |
| | | TW 202028523 A | 01-08-2020 |
| | | US 2022018017 A1 | 20-01-2022 |
| | | WO 2020101336 A1 | 22-05-2020 |
| US 2022220139 A1 | 14-07-2022 | CN 116761907 A | 15-09-2023 |
| | | EP 4277911 A1 | 22-11-2023 |
| | | JP 2024502994 A | 24-01-2024 |
| | | KR 20230130084 A | 11-09-2023 |
| | | US 2022220139 A1 | 14-07-2022 |
| | | US 2024343748 A1 | 17-10-2024 |
| | | WO 2022155090 A1 | 21-07-2022 |

EPO FORM P0459

For more details about this annex : see Official Journal of the European Patent Office, No. 12/82